# EUROPÄISCHE PATENTSCHRIFT

(11) **EP 1 340 229 B1**
(45) Veröffentlichungstag und Bekanntmachung des Hinweises auf die Patenterteilung: **27.04.2005**
(21) Anmeldenummer: 01997811.3
(22) Anmeldetag: 29.10.2001
(51) Int. Cl.: G11C 5/00

(54) **INTEGRIERTER SPEICHER MIT EINER ANORDNUNG VON NICHT-FLÜCHTIGEN SPEICHERZELLEN UND VERFAHREN ZUR HERSTELLUNG UND ZUM BETRIEB DES INTEGRIERTEN SPEICHERS**
INTEGRATED MEMORY WITH AN ARRANGEMENT OF NON-VOLATILE MEMORY CELLS AND METHOD FOR THE PRODUCTION AND OPERATION OF AN INTEGRATED MEMORY
MEMOIRE INTEGREE COMPRENANT UN ENSEMBLE DE CELLULES MEMOIRES NON VOLATILES, ET PROCEDE POUR FABRIQUER ET FAIRE FONCTIONNER CETTE MEMOIRE INTEGREE

(30) Priorität: 23.11.2000 DE 10058047
(43) Veröffentlichungstag der Anmeldung: 03.09.2003
(73) Patentinhaber: Infineon Technologies AG, 81669 München (DE)
(72) Erfinder: MÜLLER, Gerhard, D-86405 Meitingen (DE); SCHLÖSSER, Till, 01109 Dresden (DE)
(74) Vertreter: Epping Hermann & Fischer
(86) Internationale Anmeldenummer: PCT/DE2001/004091
(87) Internationale Veröffentlichungsnummer: WO 2002/043067

(56) Entgegenhaltungen:
- EP-A- 0 387 834
- EP-A- 0 613 148
- EP-A- 0 918 334
- US-A- 4 500 905

## Beschreibung

Integrierter Speicher mit einer Anordnung von nicht-flüchtigen Speicherzellen und Verfahren zur Herstellung und zum Betrieb des integrierten Speichers

Die vorliegende Erfindung betrifft einen integrierten Speicher mit einer Anordnung von nicht-flüchtigen Speicherzellen sowie ein Verfahren zur Herstellung und zum Betrieb des integrierten Speichers.

Nicht-flüchtiger Speicher wird in vielen Systemen mit diskreten Speicherbausteinen verwendet, wobei die Auswahl der verwendeten Speicherbausteine von den speziellen Anforderungen des jeweiligen Systems abhängt. Üblicherweise kommen dabei sowohl Bausteine aus Speicher mit schnellen Lese- und Schreibzeiten, z.B. SRAM (Static Random Access Memory), sowie kostengünstigere Bausteine mit langsamerem Zugriff aber höheren Integrationsdichte der Speicherelemente, z.B. Flash-Speicher, zum Einsatz.

Neben anderen Architekturen nicht-flüchtiger Speicher, etwa ferroelektrischem Speicher (FeRAM), wurde auch ferromagnetische Speicherung (MRAM) für die Verwendung in diskreten Bausteinen vorgeschlagen, wobei die Speicherung in Zellen mit Hilfe des magnetoresistivem Effektes erzielt wird. Dabei wird ausgenutzt, daß der elektrische Widerstand zweier ferromagnetischer Schichten von deren gegenseitiger Ausrichtung ihrer magnetischen Polarisation abhängt. So kann ein Zustand "0" dem elektrischen Widerstand bei paralleler Polarisationsrichtung entsprechen sowie der Zustand "1" dem elektrischen Widerstand bei antiparalleler Polarisationsrichtung. Der Unterschied im elektrischen Widerstand zwischen den beiden möglichen Ausrichtungen beträgt allerdings nur 15 % für GMR-Elemente (Giant Magnetoresistive Effect) bis hin zu 50 % für TMR-Elemente (Tunnelling Magnetoresistive Effect).

Die aus zwei ferromagnetischen Schichten bestehenden und durch eine dielektrische Schicht getrennten Elemente werden an den Schnittpunkten der sich kreuzenden Bitleitungen und Wort- bzw. Schreibleitungen angebracht, so daß eine elektrische Verbindung von der Bitleitung über den GMR- bzw. TMR-Widerstand zur Wortleitung besteht. Durch Messung des Stromes über die aktive Bit- beziehungsweise Wortleitung mit Hilfe von Leseverstärkern kann der elektrische Widerstand bestimmt und damit die gegenseitige Ausrichtung der magnetischen Polarisation der ferromagnetischen Schichten bestimmt werden.

Je nach Ausführung einer MRAM-Zelle ist es durch eine zusätzliche, zur Wortleitung parallelen und vom ferromagnetischen Element isolierten beziehungsweise durch eine mit der Wortleitung identischen Schreibleitung möglich, anhand Strom führend geschaltete Bit- und Schreibleitungen mittels Überlagerung an ihrem Kreuzungspunkt ein derart großes Magnetfeld zu generieren, daß eine 180 Grad umfassende Drehung der magnetischen Polarisationsrichtung einer ersten variablen ferromagnetischen Schicht gegenüber der in magnetischer Ausrichtung fixierten zweiten ferromagnetischen Schicht möglich wird. Wird analog zur Struktur herkömmlicher dynamischer Speicher (DRAM, Dynamic Random Access Memory) ein Netz parallel verlaufender Bitleitungen und dazu quer verlaufender Wort- bzw. Schreibleitungen verwendet, so wird unter Zuhilfenahme entsprechender Spalten- und Zeilentreiber eine Adressierung der Speicherzellen zum Lesen bzw. Schreiben ermöglicht.

Für den Aufbau von Speicherzellen mit magnetoresistivem Effekt gibt es im wesentlichen zwei Möglichkeiten. Eine erste Ausführungsform ist z.B. aus Durlam et al., "International Solid State Circuits Conference", IEEE, 2000, Seiten 130 bis 131 bekannt, wobei durch Verwendung eines Auswahltransistors in der Speicherzelle ein Strompfad von der Bitleitung über das ferromagnetische Speicherelement an das Massenpotential durch die Wortleitung aktiv geschaltet werden kann. Für den Schreibvorgang wird der Transistor durch die Wortleitung gesperrt, während durch die Schreibleitung ein Strom fließt. Diese Architektur bietet den Vorteil einer sehr schnellen Zugriffszeit von wenigen Nanosekunden, kann aber die Möglichkeiten einer sehr kleinen Dimensionierung durch das ferromagnetische Element nicht nutzen, da die beanspruchte Fläche durch den wesentlich größeren Auswahltransistor bestimmt wird und wie beim herkömmlichen dynamischen Speicher (DRAM) zu 8 F² ausfällt, wobei F die minimale Strukturgröße auf dem Substrat ist.

Aus WO 99/14760 A1 ist hingegen eine Architektur eines ferromagnetischen Speichers bekannt, bei der das Speicherelement mit magnetoresistivem Effekt direkt zwischen die Bit- und Wortleitung geschaltet sind, wobei ohne Verwendung eines Auswahltransistors der Strom an der ausgewählten Bitleitung mittels eines Leseverstärkers ausgewertet werden kann. Verursacht durch einen vergleichsweise hohen inneren Widerstand der Wort- bzw. Bitleitungen relativ zum Widerstand der Speicherzelle mit magnetoresistivem Effekt können parasitäre Strompfade auftreten. Zudem unterscheiden sich die zu messenden Stromstärken für die beiden Zustände der Speicherzelle nur um 10 bis 30 %, so daß die Widerstände der ferromagnetischen Elemente von vornherein sehr hoch dimensioniert werden müssen. Da ein Auswahltransistors bei dieser Architektur vermieden wird, kann daher mit einer Zellfläche von 4 F² eine hohe Integrationsdichte der Speicherzellen erreicht werden. Dieser Vorteil muß allerdings mit dem Nachteil einer langen Zugriffszeit von 0,5 - 1 µs abgewogen werden.

Durch Zusammenstellung diskreter Bausteine aus Speicherzellen mit magnetoresistivem Effekt lassen sich wie bei der elektrischen Speicherung den jeweiligen Systemanforderungen genügender Speichermodule aufbauen, indem z.B. sowohl Speicher mit schneller Zugriffszeit als auch solcher mit hoher Integrationsdichte in zwei diskreten Bausteinen verwendet wird. Allerdings werden auch die inhärenten Nachteile der Einzelbausteine mit in das Gesamtsystem überführt, und führen dabei nachteilig zu erheblich höheren Herstellungskosten.

Es ist die Aufgabe der vorliegenden Erfindung, eine Anordnung von Speicherzellen anzubieten, welche zu ihrer Herstellung niedrige Kosten aufweist und gleichzeitig eine hohe Integrationsdichte mit schnellen Lese- und Schreibzeiten ermöglicht.

Die Aufgabe wird gelöst durch einen integrierten Speicher mit einer Anordnung von nicht-flüchtigen Speicherzellen, welche wenigstens eine erste und eine zweite Speicherzelle mit magnetoresistivem Effekt umfaßt, die an Kreuzungspunkten jeweils zwischen Bitleitungen und dazu quer verlaufenden Wortleitungen angebracht sind, bei dem die erste Speicherzelle mit magnetoresistivem Effekt einen Transistor enthält, welcher durch die Wortleitung ansteuerbar ist und welcher für einen Zugriff auf die erste Speicherzelle mit magnetoresistivem Effekt mit der Bitleitung und dem zugehörigen Speicherelement einen Strompfad zu einem Versorgungs- oder Massenpotential bildet, und bei dem das Speicherelement der zweiten Speicherzelle mit magnetoresistivem Effekt zwischen Bitleitung und Wortleitung geschaltet ist.

Der vorliegenden Erfindung zufolge wird die vorteilhafte Ausgestaltung eines nicht-flüchtigen Speichers mit schneller Zugriffszeit und hoher Integrationsdichte innerhalb eines diskreten Speicherbausteins realisiert. Durch eine Kombination von Anteilen im integrierten Speicher, nämlich der Speicherzellen mit magnetoresistivem Effekt mit Transistor und der z.B. direkt zwischen Bit- und Wortleitung geschalteten Speicherzellen mit magnetoresistivem Effekt, können je nach Systemanforderung flexible, schnelle und preiswerte Speicherbausteine geschaffen werden, die durch die Integration auf einem diskreten Baustein erheblich niedrigere Herstellungskosten aufweisen.

Vorzugsweise werden die beiden verwendeten Architekturen für Speicherzellen mit magnetoresistivem Effekt jeweils mit eigenen Sätzen an Wort- und Bitleitungen ausgestattet. Dazu sind dann auch entsprechende Sätze an Treibern für die so entstehenden Speicherzellenfelder sowie eine entsprechende Logik für die Adressierung vorzusehen. Hingegen ist auch eine gemeinsame Ausgestaltung innerhalb eines Speicherzellenfeldes möglich. Während die Speicherzellenfelder mit magnetoresistivem Effekt mit Auswahltransistoren im allgemeinen an das monokristalline Siliziumsubstrat gebunden sind, sind für die direkt zwischen Bit- und Wortleitung geschalteten Speicherzellen auch andere Ausführungsformen der relativen Anordnung in Betracht zu ziehen. Durch platzsparende Assoziierung an andere Bauelemente auf dem Speicherbaustein oder auf einem Logikbaustein mit assoziiertem Speicher kann zudem eine noch wirkungsvollere Integrationsdichte erzielt werden.

In einer weiteren vorteilhaften Ausgestaltung der vorliegenden Erfindung wird eine Stapelung der Speicherzellenfelder, die sich in der untersten, substratseitigen Ebene aus den Speicherzellen mit magnetoresistivem Effekt mit Transistor, und in dem darüber folgenden Ebenen aus den Speicherzellen mit zwischen Bit- und Wortleitung geschalteten Speicherelementen zusammensetzen, aus der Substratebene heraus bis in höhere Schichten erreicht. Hierdurch wird eine maximale Anzahl von Speicherzellen je Substratgrundfläche erreicht, wobei die Stapelungstiefe lediglich von der Treiberlogik und ihrem zwangsläufig größer werdenden Abstand zum jeweiligen Speicherzellenfeld abhängt. Andererseits wird auch mit größer werdender Stapelungstiefe der Anteil an schnellem Speicher bestehend aus Speicherzellen mit magnetoresistivem Effekt mit Transistoren immer geringer, so daß mit einer ausgewogenen Kombination aus Anteilen beider Speicherarten vorteilhaft höhere Integrationsdichten, schnellerer Zugriff und niedrigere Herstellungskosten erreicht werden.

In einer weiteren Ausgestaltung der Erfindung wird auch eine Kombination von Speicherzellen mit GMR-Elementen sowie mit TMR-Elementen betrachtet. Durch diese Ausführungsform wird eine weitere Leistungs- und Kostenabstufung innerhalb des Speichers ermöglicht.

In einer weiteren Ausgestaltung der vorliegenden Erfindung wird das gezielte Durchbrechen der nur wenige Nanometer dikken dielektrischen Barriereschicht im TMR-Element betrachtet. Dies wird durch Anlegen einer hohen Spannung an die betreffenden Zellen erreicht, wonach die Polarisationsrichtung der frei einstellbaren ferromagnetischen Schicht an jene der fixierten ferromagnetischen Schicht angekoppelt wird und damit ebenfalls fixiert ist. Der Zustand der Polarisationsausrichtung der Speicherzelle mit magnetoresistivem Effekt entspricht dadurch dauerhaft demjenigen, bei dem das Durchbrechen durchgeführt wurde. Hierdurch kann ein leistungsfähiges, fest vorgrammiertes ROM (Read-Only Memory) realisiert werden.

Eine weitere Ausgestaltung der vorliegenden Erfindung stellt die Speicherzelle mit Diode dar. Diese kann insbesondere für den Fall vorgesehen werden, bei dem die Speicherzelle nicht durch einen Transistor gesteuert wird. Die Diode wird dabei mit dem Speicherelement zwischen die Wort- und Bitleitung in Reihe geschaltet. Dadurch wird ein Verfahren ermöglicht, mit dem durch eine geeignete Spannungsverteilung über die Wort- bzw. Bitleitungen der Speicherzellen parasitäre Ströme verhindert werden können.

Bei diesem Verfahren, das zum Auslesen einer Speicherzelle mit magnetoresistivem Effekt mit Diode angewandt wird, wird von allen Wortleitungen des Speicherzellenfeldes diejenige mit einer höheren Spannung betrieben, die die auszulesende Speicherzelle durchläuft, während alle anderen Wortleitungen mit einer niedrigeren, zweiten Spannung betrieben werden. Wie im herkömmlichen Fall wird zwar die Bitleitung der auszulesenden Speicherzelle mit der zweiten niedrigeren Spannung betrieben, jedoch alle anderen Bitleitungen werden mit der ersten höheren, wie jener bei der Wortleitung der auszulesenden Speicherzelle betriebenen Spannung gesteuert. Dadurch liegt ein Spannungsgefälle nur zwischen der Wortleitung und der Bitleitung der auszulesenden Speicherzelle vor. Für alle anderen Speicherzellen liegen entweder gleiche Spannungen beziehungsweise Spannungssteigungen vor. In diesem Fall verhindern die Dioden in den Speicherzellen das Fließen entgegengesetzter Ströme. Dadurch werden wirkungsvoll parasitäre Strompfade verhindert. Die Widerstände der Speicherelemente können dadurch niedriger dimensioniert und die Zugriffsgeschwindigkeiten vorteilhaft erhöht werden.

Eine weitere vorteilhafte Ausgestaltung der vorliegenden Erfindung betrifft die gemeinsame Zuordnung von Bit- oder Wortleitungen zu Speicherzellen aus übereinanderliegenden Speicherzellenfeldern. Dabei befinden sich zwischen den übereinanderliegenden Speicherzellen bzw. Speicherzellenfeldern keine isolierenden Schichten, sondern die oben liegenden Leitungen des unteren Speicherzellenfeldes werden in umgekehrter Anordnung als Leitung gleichen Typs von der darüber liegenden Schicht an Speicherzellen verwendet. Zwar wird dadurch nur ein abwechselnder Zugriff auf die jeweiligen Speicherzellenfelder ermöglicht und somit die Speicherzugriffsrate insgesamt nicht erhöht, aber die Zahl der Prozeßschritte zur Herstellung der Speicherzellenfelder, insbesondere die Zahl der Lithographieschritte kann erheblich verringert werden. Daraus ergibt sich eine erhebliche Einsparung an Herstellungskosten sowie eine noch höhere Integrationsdichte.

Der Vorteil der Zusammenfassung der beiden Typen von Speicherzellen mit magnetoresistivem Effekt in genau einem integrierten Speicher wird besonders deutlich bei dem Verfahren zur Herstellung dieser Anordnung. Die Stapelung von der untersten Speicherzellenschicht auf dem Substrat bis hin zur obersten Speicherzellenschicht bestehend aus Speicherzellen, die zwischen Wort- bzw. Bitleitungen geschaltet sind, kann nämlich in einer Prozeßfolge dargestellt werden.

Die Anordnung von Speicherzellen mit magnetoresistivem Effekt in einem integrierten Speicher und das Verfahren zur Herstellung dieser Anordnung sollen im folgenden anhand eines Ausführungsbeispiels näher erläutert werden. Es zeigen:
- Figur 1: zeigt Ersatzschaltpläne für Speicherzellen mit magnetoresistivem Effekt mit Transistor (a), mit direkt zwischen Wort- und Bitleitung geschaltetem Speicherelement (b) und mit zwischen Wort- und Bitleitung in Reihe geschaltetem Speicherelement und einer Diode (c).
- Figur 2: zeigt einen Querschnitt durch die Speicherzellen bei einer Prozeßabfolge zur Herstellung des integrierten Speichers in 5 aufeinanderfolgenden Schritten (a-e).

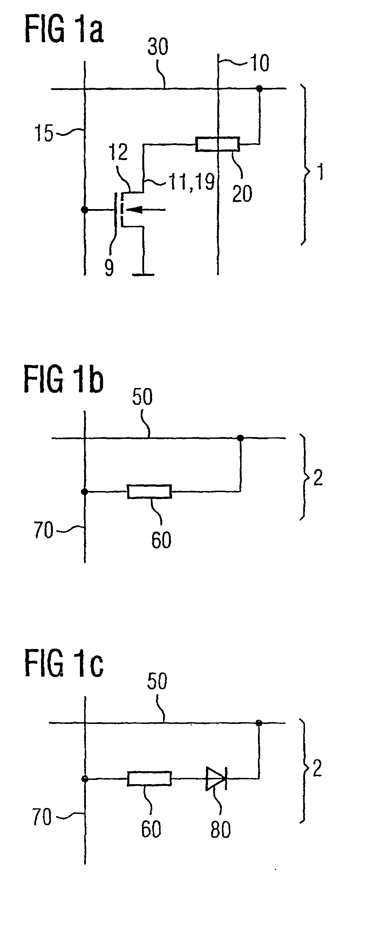

Der hier beispielhaft gezeigte integrierte Speicher besteht aus 2 Typen von Speicherzellen, deren Ersatzschaltbilder in Figur 1a und 1b dargestellt sind. Substratseitig (siehe Figur 1a) befindet sich eine Vielzahl von Speicherzellen mit magnetoresistivem Effekt 1 mit Transistor 9 an den Kreuzungspunkten von untereinander vorzugsweise parallelen Wortleitungen 15 und dazu jeweils quer verlaufenden Bitleitungen 30. Zum Auslesen von Informationen schaltet die Wortleitung 15 den Transistor 9 auf leitend, welcher einen Strompfad von der Bitleitung 30 über das magnetoresistive Speicherelement 20, den Brückenkontakt 19 und den Metallkontakt 11 an ein Massenpotential 14 ermöglicht. Statt des Massenpotentials 14 ist auch eine rückführende Leitung mit Spannungsversorgung möglich. Die Verwendung des Transistors 9 gewährleistet, daß nur der genannte Strompfad vorliegt, also insbesondere keine nennenswerten Ströme über Speicherelemente 20 anderer, nicht ausgewählter Wortleitungen 15 ausweichen können, da sich deren Transistoren 9 in einem nichtleitenden Zustand befinden.

Zum Schreiben von Information wird die jeweils zur Wortleitung 15 parallele, nahe am Speicherelement 20 verlaufende Schreibleitung 10 mit Strom versorgt, so daß bei gleichzeitiger Aktivierung der Bitleitung 30 ein hinreichend großes, überlagertes Magnetfeld induziert wird, welches die magnetische Polarisation im Speicherelement 20 beeinflußt.

Dieses substratseitige, durch die Bit- und Wortleitungen aufgespannte Feld von Speicherzellen wird - durch eine isolierende Schicht getrennt - von einem weiteren Speicherzellenfeld überlagert. Eine Speicherzelle mit magnetoresistivem Effekt 2 dieses Feldes ist in Figur 1b gezeigt. Darin fließt zum Auslesen bei aktivierter Wortleitung 70 ein Strom über das Speicherelement 60 zur Bitleitung 50. Mittels z.B. eines invertierenden Leseverstärkers kann daraus ein Signal erzeugt werden, welches durch eine Zuordnung zu einem der beiden Polarisationszustände des aktiven Speicherelementes ausgewertet werden kann.

Um die bei dieser Architektur möglicherweise auftretenden parasitären Strompfade zu verhindern kann in einer erweiterten Ausführung das Einfügen einer Diode 80 in den Strompfad zwischen Wortleitung 70 und Bitleitung 50 betrachtet werden, welches in Figur 1c dargestellt ist. Bei Steuerung der zur auszulesenden Speicherzelle zugehörigen Wortleitung 70 mit z.B. 3 Volt sowie aller weiteren Wortleitungen mit 0 Volt, und der zur auszulesenden Speicherzelle zugehörigen Bitleitung 50 mit 0 Volt sowie aller weiteren Bitleitungen 70 mit 3 Volt ergibt sich nur für den Strompfad durch das auszulesende Speicherelement 60 eine positive Spannungsdifferenz zwischen der Wortleitung 70 und der Bitleitung 50, wodurch nur die zu diesem Speicherelement zugehörige Diode 80 in Flußrichtung betrieben wird.

Zum Schreiben von Information wird bei diesem Typ von Speicherzellen der gleiche Mechanismus verwendet wie bei der Speicherzelle mit magnetoresistivem Effekt 1 mit Transistor 9, nur daß in diesem Beispiel die Wortleitung 70 selbst als Schreibleitung benutzt wird.

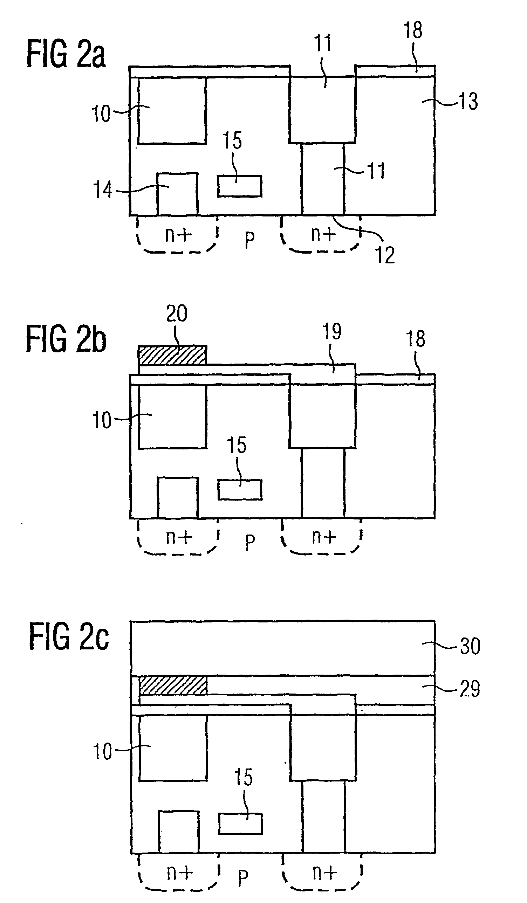

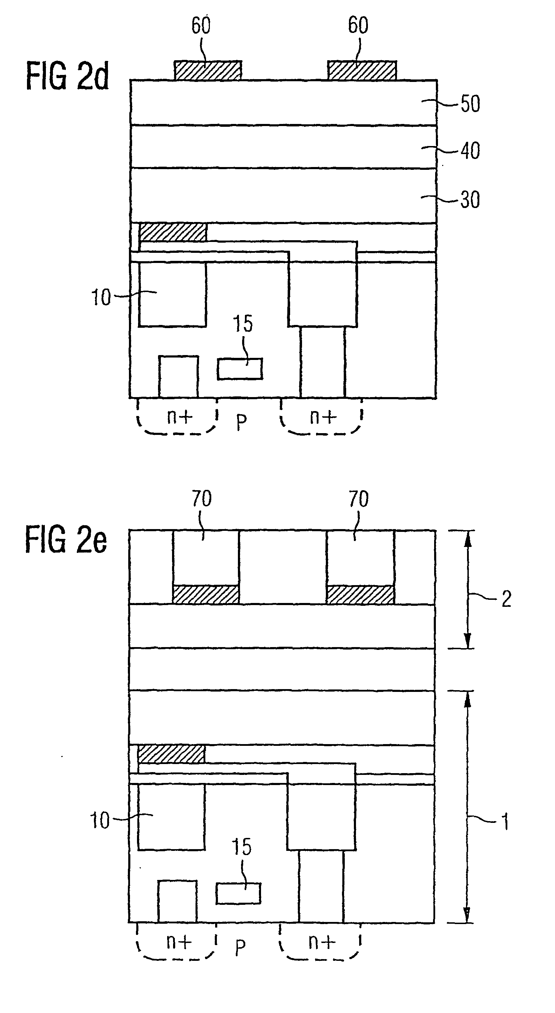

Für die Herstellung der übereinander gelagerten Anordnung von Speicherzellen wird die unterste Speicherzelle mit magnetoresistivem Effekt 1 wie herkömmlich auf dem CMOS-Basisprozeß aufgebaut, zu dem substratseitig zum Transistor 9 ein Transistorkontakt 12 über einen Metallkontakt 11 besteht, wie in Figur 2a gezeigt ist. Die zu diesem Transistor gehörige Gateelektrode stellt die Wortleitung 15 der Speicher mit magnetoresistivem Effekt 1 mit Transistor 9 dar. Der Metallkontakt 11 wird isoliert durch eine Oxid- und Nitridschicht 13, durch welche auch die Schreibleitung 10 senkrecht durch die Bildebene in Figur 2a verläuft. Auf diese planarisierte Schicht wird eine dünne dielektrische Schicht von etwa 10 bis 20 nm abgeschieden und der Metallkontakt 11 in einem Lithographieund Ätzschritt freigelegt. Nach Aufbringen der Metallschicht für den Brückenkontakt 19 (englisch: "strap contact") wird der TMR-Film für das Speicherelement 20 abgeschieden und beide Schichten durch Lithographie- und Ätzschritte auf die gewünschte Formstruktur reduziert, wie in Figur 2b gezeigt ist.

Nach dem Abscheiden und Planarisieren einer weiteren Isolationsschicht 29 wird in weiteren Abscheide-, Lithographie-, Ätz-, Metallabscheidungs-, und Planarisierungsschritten als Metallinie die Bitleitung 30 strukturiert, wie in Figur 2c zu sehen ist. Mit diesem Schritt ist der Aufbau der Speicherzelle mit magnetoresistivem Effekt 1 mit Transistor abgeschlossen.

Um eine hohe Integrationsdichte und damit niedrige Herstellungskosten zu erreichen, wird eine zweite Speicherzelle mit magnetoresistivem Effekt 2 über die Speicherzelle mit magnetoresistivem Effekt 1 gelagert. Wie in Figur 2d dargestellt, wird dazu zunächst eine weitere Isolationsschicht 40, bestehend aus Plasmanitrid und -oxid aufgebracht, wonach in einem weiteren Lithographie- und Ätzschritt mit anschließender Kupferabscheidung die Bitleitung 50 als dritte Metallisierungsebene eingeführt wird. Nach der chemisch-mechanischen Planarisierung wird der TMR-Film für das Speicherelement 60 aufgebracht, welcher aus den zwei ferromagnetischen Schichten getrennt von einer dünnen dielektrischen Schicht besteht. Wie aus Figur 2d ersichtlich, erreicht man für die zweite Speicherzellenebene eine höhere Packungsdichte an Speicherelementen als in der ersten unteren Speicherebene, welches durch die Fläche des sich unterhalb des Transistorkontaktes 12 anschließenden Transistors begründet ist, wohingegen die Fläche der in Figur 2d dargestellten oberen Speicherzelle durch die Größe des Speicherelementes 60 bzw. den minimalen Leitungsabstand zweier Leitungen dominiert wird.

Nach Aufbringen einer weiteren Isolationsschicht, eines Lithografie- und Ätzschrittes sowie einer Kupferverfüllung der Gräben der vierten Metallebene erhält man die Wortleitungen 70, welche nun die Speicherelemente 60 aus TMR-Film zwischen sich und den Bitleitungen 50 einschließen. Nach weiterer Planarisierung und Isolation ist nun auch die Erstellung der Speicherzelle mit magnetoresistivem Effekt 2 abgeschlossen. In nachfolgenden Lagen können nun Speicherzellen mit magnetoresistivem Effekt 2 wiederholt übereinander gestapelt werden.

In einer Erweiterung dieses Durchführungsbeispiels kann durch Integration einer Vorrichtung zum Anlegen einer Spannung von z.B. 10 Volt an die Wortleitung 70 in dem Speicherbaustein das gezielte Durchbrechen der nach heutigem Stand der Technik nur etwa 1-2 nm dicken dielektrischen Schicht zwischen den beiden ferromagnetischen Schichten in den Speicherzellen erreicht werden. Dies entspricht der Realisierung von einmalig programmierbaren Speicher gemäß der vorliegenden Erfindung.

Um in diesem Durchführungsbeispiel eine Kombination von 1 Gb kostengünstigen Massenspeicher und 128 Mb schnellen, leistungsfähigen Speicher herzustellen, wird aus den Speicherzellen mit magnetoresistivem Effekt 1 mit Transistor eine substratseitige Lage von 128 Mb für das Speicherzellenfeld zur Verfügung gestellt, welches nicht-flüchtigen Speicher bereitstellt, und gleichzeitig die Leistungsfähigkeit von statischem elektrischem Speicher (SRAM) anbietet. Da der Flächenbedarf einer Speicherzelle mit magnetoresistivem Effekt 2 mit 4 F² nur die Hälfte des Flächenbedarfs der Speicherzelle mit magnetoresistivem Effekt 1 mit Transistor beträgt, können von diesem Typ kostengünstigeren Massenspeichers vier Lagen mit 256 Mb direkt über das substratseitig bestehende Speicherzellenfeld gestapelt werden. Hierbei ist lediglich auf die Reservierung von Substratfläche für die Treiber der Speicherzellenfelder zu berücksichtigen. Somit wird Speicher mit schnellem Zugriff, niedriger Degradationsrate im Vergleich zu elektrischen Speicher, hoher Integrationsdichte und damit niedrigen Herstellungskosten zur Verfügung gestellt.

### Bezugszeichenliste

- 1: Speicherzelle mit magnetoresistivem Effekt, mit Transistor
- 2: Speicherzelle mit magnetoresistivem Effekt, Speicherelement zwischen Wort- und Bitleitung geschaltet
- 9: Transistor
- 10: Schreibleitung, Speicherzelle 1
- 11: Metallkontakt
- 12: Transistorkontakt
- 13: Isolationsschicht
- 14: Leitung mit Massenpotential
- 15: Wortleitung, Speicherzelle 1, Gateelektrode
- 18: Dielektrische Schicht
- 19: Brückenkontakt
- 20: Speicherelement, bestehend aus TMR-Film
- 29: Isolationsschicht
- 30: Bitleitung, Speicherzelle 1
- 40: Isolationsschicht
- 50: Bitleitung, Speicherzelle 2
- 60: Speicherelement, bestehend aus TMR-Film
- 70: Wortleitung, Speicherzelle 2
- 80: Diode

## Patentansprüche

1. Integrierter Speicher mit einer Anordnung von nicht-flüchtigen Speicherzellen (1, 2), welche wenigstens eine erste und eine zweite Speicherzelle mit magnetoresistivem Effekt umfaßt, die an Kreuzungspunkten jeweils zwischen Bitleitungen (30, 50) und dazu quer verlaufenden Wortleitungen (15, 70) angeordnet sind, bei dem
(a) die erste Speicherzelle mit magnetoresistivem Effekt (1) einen Transistor (9) enthält, welcher durch eine der Wortleitungen ansteuerbar ist, und welcher für einen Zugriff auf die erste Speicherzelle mit magnetoresistivem Effekt (1) mit einer der Bitleitungen (30) und dem zugehörigen Speicherelement (20) einen Strompfad zu einem Versorgungsoder Massenpotential (14) bildet, und
(b) das Speicherelement (60) der zweiten Speicherzelle mit magnetoresistivem Effekt (2) zwischen einer der Bitleitungen (50) und einer der Wortleitungen (70) geschaltet ist.

2. Integrierter Speicher nach Anspruch 1,
**dadurch gekennzeichnet,**
**daß** der Speicher in einem Substrat angeordnet ist, die erste Speicherzelle mit magnetoresistivem Effekt (1) mit einer Vielzahl von weiteren Speicherzellen mit magnetoresistivem Effekt (1) mit Transistor (9) ein substratseitiges Speicherzellenfeld bildet und daß die zweite Speicherzelle mit magnetoresistivem Effekt (2) mit einer Vielzahl von Speicherzellen mit magnetoresistivem Effekt (2) ein über dem substratseitigen Speicherzellenfeld angeordnetes Speicherzellenfeld bildet.

3. Integrierter Speicher nach einem der Ansprüche 1 oder 2,
**dadurch gekennzeichnet,**
**daß** eine der Speicherzellen ein Speicherelement (20, 60) mit einem großen magnetoresistiven Effekt (GMR) und eine andere Speicherzelle ein Speicherelement (20, 60) mit einem tunnelmagnetoresistiven Effekt (TMR) aufweist.

4. Integrierter Speicher nach einem der Ansprüche 2 oder 3,
**dadurch gekennzeichnet,**
**daß** zu einem Speicherzellenfeld eine Vorrichtung zum Anlegen einer hohen Spannung an Bitleitungen (30, 50) und Wortleitungen (15, 70) zum Durchbrechen einer dünnen dielektrischen Schicht im Speicherlelement (20, 60) angeschlossen ist.

5. Integrierter Speicher nach einem oder mehreren der Ansprüche 1 bis 4,
**dadurch gekennzeichnet,**
**daß** jede der Speicherzellen mit magnetoresistivem Effekt (2) eines der Speicherzellenfelder eine Diode besitzt, die mit dem Speicherelement (60) zwischen die Wortleitung (70) und die Bitleitung (50) in Reihe geschaltet ist.

6. Integrierter Speicher nach einem oder mehreren der Ansprüche 2 bis 5,
**dadurch gekennzeichnet,**
**daß** jeweils zwei übereinanderliegende Speicherzellen mit magnetoresistivem Effekt (2) aus verschiedenen Speicherzellenfeldern an eine gemeinsame Bitleitung (50) angeschlossen sind.

7. Verfahren zur Herstellung des integrierten Speichers nach einem der Ansprüche 1 bis 5,
**dadurch gekennzeichnet,**
**daß** die erste Speicherzelle mit magnetoresistivem Effekt (1) auf dem Substrat einschließlich eines CMOS-Prozesses zur Erstellung des Transistors (9) gebildet wird, anschließend über der ersten Speicherzelle eine isolierende Schicht (40) erzeugt wird und anschließend die zweite Speicherzelle mit magnetoresistivem Effekt (2) auf der isolierenden Schicht (40) aufgebracht wird.

8. Verfahren zum Betrieb des integrierten Speichers nach Anspruch 5, bei der zum Auslesen einer Speicherzelle mit magnetoresistivem Effekt (2) mit Diode in einem ersten Schritt die mit der auszulesenden Speicherzelle verbundene Wortleitung (70) mit einer ersten Spannung angesteuert wird, und alle anderen Wortleitungen (70) mit einer zweiter Spannung angesteuert werden, welche niedrigerer als die erste Spannung ist, und bei dem die mit der auszulesenden Speicherzelle verbundene Bitleitung (50) mit der zweiten Spannung betrieben wird, und alle anderen Bitleitungen (50) mit der ersten Spannung betrieben werden, und bei dem in einem zweiten Schritt der Stromfluß durch die Bitleitung (50) der auszulesenden Speicherzelle mittels eines Leseverstärkers ausgewertet wird.

## Claims

1. Integrated memory with an arrangement of non-volatile memory cells (1, 2), which comprises at least a first and a second memory cell with a magnetoresistive effect, which are arranged at crossover points in each case between bit lines (30, 50) and word lines (15, 70) running transversely with respect thereto, in which
(a) the first memory cell with a magnetoresistive effect (1) contains a transistor (9) which can be driven by one of the word lines and which forms, for an access to the first memory cell with a magnetoresistive effect (1), with one of the bit lines (30) and the associated memory element (20), a current path to a supply or earth potential (14), and
(b) the memory element (60) of the second memory cell with a magnetoresistive effect (2) is connected between one of the bit lines (50) and one of the word lines (70).

2. Integrated memory according to Claim 1,
**characterized**
**in that** the memory is arranged in a substrate, the first memory cell with a magnetoresistive effect (1) forms, with a multiplicity of further memory cells with a magnetoresistive effect (1) with transistor (9), a substrate-side memory cell array, and in that the second memory cell with a magnetoresistive effect (2) forms, with a multiplicity of memory cells with a magnetoresistive effect (2), a memory cell array arranged above the substrate-side memory cell array.

3. Integrated memory according to either of Claims 1 and 2,
**characterized**
**in that** one of the memory cells has a memory element (20, 60) with a giant magnetoresistive effect (GMR) and another memory cell has a memory element (20, 60) with a tunnelling magnetoresistive effect (TMR).

4. Integrated memory according to either of Claims 2 and 3,
**characterized**
**in that** a device for the application of a high voltage to bit lines (30, 50) and word lines (15, 70) for the breakdown of a thin dielectric layer in the memory element (20, 60) is connected to a memory cell array.

5. Integrated memory according to one or more of Claims 1 to 4,
**characterized**
**in that** each of the memory cells with a magnetoresistive effect (2) of one of the memory cell arrays has a diode which is connected in series with the memory element (60) between the word line (70) and the bit line (50).

6. Integrated memory according to one or more of Claims 2 to 5,
**characterized**
**in that** in each case two memory cells - lying one above the other - with a magnetoresistive effect (2) from different memory cell arrays are connected to a common bit line (50).

7. Method for fabricating the integrated memory according to one of Claims 1 to 5,
**characterized**
**in that** the first memory cell with a magnetoresistive effect (1) is formed on the substrate including a CMOS process for producing the transistor (9), an insulating layer (40) is subsequently produced above the first memory cell, and the second memory cell with a magnetoresistive effect (2) is subsequently applied on the insulating layer (40).

8. Method for operating the integrated memory according to Claim 5, in which, in order to read from a memory cell with a magnetoresistive effect (2) with diode, in a first step, the word line (70) connected to the memory cell to be read is driven with a first voltage, and all the other word lines (70) are driven with a second voltage, which is lower than the first voltage, and in which the bit line (50) connected to the memory cell to be read is operated with the second voltage and all the other bit lines (50) are operated with the first voltage, and in which, in a second step, the current flow through the bit line (50) of the memory cell to be read is evaluated by means of a sense amplifier.

## Revendications

1. Mémoire intégrée comprenant un ensemble de cellules (1, 2) de mémoire non volatile, qui comprend au moins une première et une deuxième cellules de mémoire à effet magnéto-résistif qui sont disposées aux points d'intersection de lignes (30, 50) de bits et de lignes (15, 70) de mots qui leur sont transversales, dans laquelle
(a) la première cellule de mémoire à effet (1) magnéto-résistif comporte un transistor (9), qui peut être commandé par l'une des lignes de mots et qui, pour l'accès à la première cellule de mémoire à effet (1) magnéto-résistif, forme avec l'une des lignes (30) de bits et l'élément (20) de mémoire associé un trajet de courant menant à un potentiel d'alimentation ou à un potentiel (14) de masse, et
(b) l'élément (60) de mémoire de la deuxième cellule de mémoire à effet (2) magnéto-résistif est monté entre l'une des lignes (50) de bits et l'une des lignes (70) de mots.

2. Mémoire intégrée suivant la revendication 1, **caractérisée en ce que** la mémoire est disposée dans un substrat, la première cellule de mémoire à effet (1) magnéto-résistif forme avec une pluralité d'autres cellules de mémoire à effet (1) magnéto-résistif ayant un transistor (9) un champ de cellules de mémoire côté substrat et **en ce que** la deuxième cellule de mémoire à effet (2) magnéto-résistif forme avec une pluralité de cellules de mémoire à effet (2) magnéto-résistif un champ de cellules de mémoire disposé au-dessus du champ de cellules de mémoire côté substrat.

3. Mémoire intégrée suivant l'une des revendications 1 ou 2, **caractérisée en ce que** l'une des cellules de mémoire a un élément (20, 60) de mémoire ayant un grand effet (GMR) magnéto-résistif et une autre cellule de mémoire a un élément (20, 60) de mémoire ayant un effet (TMR) magnéto-résistif tunnel.

4. Mémoire intégrée suivant l'une des revendications 2 ou 3, **caractérisée** à ce qu'à un champ de cellules de mémoire est relié un dispositif d'application d'une haute tension aux lignes (30, 50) de bits et aux lignes (15, 70) de mots pour le claquage d'une mince couche diélectrique de l'élément (20, 60) de mémoire.

5. Mémoire intégrée suivant l'une ou plusieurs des revendications 1 à 4, **caractérisée en ce que** chacune des cellules de mémoire à effet (2) magnéto-résistif de l'un des champs de cellules de mémoire a une diode qui est montée en série avec l'élément (60) de mémoire entre la ligne (70) de mots et la ligne (50) de bits.

6. Mémoire intégrée suivant l'une ou plusieurs des revendications 2 à 5, **caractérisée en ce que** respectivement deux cellules de mémoire superposées à effet (2) magnéto-résistif de champs de cellules de mémoire différents sont reliées à une ligne (50) de bits commune.

7. Procédé de fabrication de la mémoire intégrée suivant l'une des revendications 1 à 5, **caractérisé en ce que** l'on forme la première cellule de mémoire à effet (1) magnéto-résistif sur le substrat, y compris d'un procédé CMOS, pour la production du transistor (9), on produit ensuite au-dessus de la première cellule de mémoire une couche (40) isolante et on dépose ensuite la deuxième cellule de mémoire à effet (2) magnéto-résistif sur la couche (40) isolante.

8. Procédé pour faire fonctionner la mémoire intégrée suivant la revendication 5, dans lequel pour lire dans une cellule de mémoire à effet (2) magnéto-résistif ayant une diode, on applique dans un premier stade une première tension à la ligne (70) de mots reliée à la cellule de lecture à lire et on applique à toutes les autres lignes (70) de mots une deuxième tension plus basse que la première tension, et on fait fonctionner la ligne (50) de bits reliée à la cellule de mémoire à lire avec la deuxième tension et toutes les autres lignes (50) de bits avec la première tension et on exploite au moyen d'un amplificateur de lecture le flux de courant passant dans la ligne (50) de bits de la cellule de mémoire à lire.
